# EUROPÄISCHE PATENTSCHRIFT

(11) **EP 3 130 017 B1**
(45) Veröffentlichungstag und Bekanntmachung des Hinweises auf die Patenterteilung: **07.08.2019**
(21) Anmeldenummer: 15717828.6
(22) Anmeldetag: 31.03.2015
(51) Int. Cl.: H01L 51/52, H01L 27/32

(54) **ORGANISCHE LEUCHTDIODE MIT MEHREREN LEUCHTSEGMENTEN**
ORGANIC LIGHT-EMITTING DIODE HAVING A PLURALITY OF LIGHT-EMITTING SEGMENTS
DIODE ÉLECTROLUMINESCENTE ORGANIQUE COMPORTANT PLUSIEURS SEGMENTS LUMINESCENTS

(30) Priorität: 08.04.2014 DE 102014104979
(43) Veröffentlichungstag der Anmeldung: 15.02.2017
(73) Patentinhaber: OSRAM OLED GmbH, 93049 Regensburg (DE)
(72) Erfinder: DIEKMANN, Karsten, 94371 Rattenberg (DE); INGLE, Andrew, 85391 Allershausen (DE); FARRNBACHER, Jörg, 93049 Regensburg (DE)
(74) Vertreter: Epping - Hermann - Fischer
(86) Internationale Anmeldenummer: PCT/EP2015/057087
(87) Internationale Veröffentlichungsnummer: WO 2015/155074

(56) Entgegenhaltungen:
- WO-A1-2011/007296
- WO-A2-2007/004121
- JP-A- 2009 048 808

## Beschreibung

Die Erfindung betrifft eine organische Leuchtdiode, die mehrere Leuchtsegmente aufweist, wobei die mehreren Leuchtsegmente zur Emission von Strahlung mit verschiedenen Helligkeiten vorgesehen sind.

Diese Patentanmeldung beansprucht die Priorität der deutschen Patentanmeldung 10 2014 104 979.9. Eine organische Leuchtdiode, die mehrere Leuchtsegmente mit verschiedenen Helligkeiten aufweist, kann dadurch realisiert werden, dass die mehreren Segmente mit separaten Elektroden versehen werden, die über separate Zuleitungen mit verschiedenen Stromstärken betrieben werden können. Die separate Kontaktierung der Segmente erhöht den Herstellungsaufwand im Vergleich zu einer nicht segmentierten organischen Leuchtdiode. Aufgrund der zwischen den Segmenten geführten Zuleitungen kann weiterhin der Abstand zwischen den Segmenten nicht beliebig vermindert werden. JP 2009/048808 offenbart eine OLED mit einer strukturierten Grundelektrode.

Der Erfindung liegt die Aufgabe zugrunde, eine verbesserte organische Leuchtdiode mit mehreren Leuchtsegmenten anzugeben, die vergleichsweise einfach herstellbar ist und einen geringen Abstand zwischen benachbarten Leuchtsegmenten ermöglicht.

Diese Aufgabe wird durch eine organische Leuchtdiode mit den Merkmalen des Patentanspruchs 1 gelöst. Vorteilhafte Ausgestaltungen und Weiterbildungen der Erfindung sind Gegenstand der abhängigen Ansprüche.

Gemäß zumindest einer Ausführungsform umfasst die organische Leuchtdiode ein erstes Leuchtsegment und mindestens ein zweites Leuchtsegment, wobei die Leuchtsegmente zur Emission von Strahlung mit verschiedenen Helligkeiten vorgesehen sind. Das erste Leuchtsegment und das zweite Leuchtsegment weisen eine gemeinsame erste Elektrode und eine gemeinsame zweite Elektrode auf. Die erste Elektrode kann zum Beispiel die Anode und die zweite Elektrode die Kathode der organischen Leuchtdiode sein. Alternativ kann die erste Elektrode die Kathode und die zweite Elektrode die Anode sein.

Bei der organischen Leuchtdiode weist die erste Elektrode vorteilhaft mindestens eine Trennlinie auf, wobei die laterale elektrische Leitfähigkeit der ersten Elektrode im Bereich der Trennlinie vermindert ist. Die Trennlinie trennt das zweite Leuchtsegment von dem ersten Leuchtsegment, wobei das zweite Leuchtsegment im Betrieb eine geringere Helligkeit als das erste Leuchtsegment aufweist.

Erfindungsgemäß wird die erste Elektrode von der Trennlinie nicht vollständig durchtrennt. Die Trennlinie ist vielmehr derart ausgeführt, dass die elektrische Leitfähigkeit im Bereich der Trennlinie zwar vermindert ist, aber dennoch eine elektrisch leitende Verbindung zwischen einem Bereich der ersten Elektrode im ersten Leuchtsegment und einem Bereich der ersten Elektrode im zweiten Leuchtsegment besteht. Die erste Elektrode dient sowohl als erste Elektrode für das erste Leuchtsegment als auch für das zweite Leuchtsegment. Eine nicht vollständige Durchtrennung der ersten Elektrode durch die Trennlinie kann insbesondere bedeuten, dass eine Dicke der ersten Elektrode entlang der Trennlinie vermindert ist, oder dass die erste Elektrode entlang der Trennlinie stellenweise durch Ausnehmungen unterbrochen ist.

Bei der hier beschriebenen organischen Leuchtdiode wird eine verminderte Helligkeit des zweiten Leuchtsegments im Vergleich zum ersten Leuchtsegment dadurch erzielt, dass der Stromfluss durch das zweite Leuchtsegment aufgrund der verminderten elektrischen Leitfähigkeit der Trennlinie, welche das zweite Leuchtsegment von dem ersten Leuchtsegment separiert, vermindert ist. Zum Betrieb des zweiten Leuchtsegments mit verminderter Helligkeit ist daher vorteilhaft keine separate Zuleitung zum Anschluss des zweiten Leuchtsegments an eine Strom- oder Spannungsquelle erforderlich. Vielmehr resultieren die verschiedenen Helligkeiten des ersten Leuchtsegments und des zweiten Leuchtsegments aus einer durch die Trennlinie gebildeten Struktur in der gemeinsamen ersten Elektrode. Da für das zweite Leuchtsegment keine separaten Zuleitungen benötigt werden, können das erste Leuchtsegment und das zweite Leuchtsegment einen vergleichsweise geringen Abstand voneinander aufweisen. Insbesondere kann der Abstand zwischen dem ersten Leuchtsegment und dem zweiten Leuchtsegment der Breite der Trennlinie entsprechen.

Bei der organischen Leuchtdiode weisen die erste Elektrode und die zweite Elektrode vorteilhaft jeweils einen einzigen Anschlusskontakt zur Verbindung der organischen Leuchtdiode mit einer Strom- oder Spannungsquelle auf.

Gemäß zumindest einer Ausführungsform grenzt ein elektrischer Anschlusskontakt der ersten Elektrode an das erste Leuchtsegment an. Die mit der Trennlinie strukturierte erste Elektrode ist mit anderen Worten in dem Bereich des ersten Leuchtsegments, das die größere Helligkeit aufweist, mit einem Anschlusskontakt versehen. An dem elektrischen Anschlusskontakt ist die erste Elektrode vorteilhaft mit einer Strom- oder Spannungsquelle verbunden. Das zweite Leuchtsegment, das durch die Trennlinie von dem ersten Leuchtsegment getrennt ist, weist kein separater elektrischer Anschlusskontakt der ersten Elektrode auf. Vielmehr ist der Bereich der ersten Elektrode im zweiten Leuchtsegment vorzugsweise ausschließlich über den Bereich der ersten Elektrode im ersten Leuchtsegment und den daran angrenzenden Anschlusskontakt mit der Strom- oder Spannungsquelle verbunden.

Die zweite Elektrode ist vorteilhaft nicht strukturiert und weist ebenfalls nur einen einzigen Anschlusskontakt zur Verbindung mit der Strom- oder Spannungsquelle auf.

Gemäß zumindest einer Ausführungsform ist die mindestens eine Trennlinie durch eine linienförmige Vertiefung in der ersten Elektrode gebildet. In diesem Fall weist die erste Elektrode entlang der Trennlinie eine geringere Dicke als außerhalb der Trennlinie auf. Beispielsweise kann die Dicke der ersten Elektrode entlang der Trennlinie um mindestens 25 %, mindestens 50 % oder mindestens 75 % vermindert sein.

Durch die verminderte Dicke der ersten Elektrode im Bereich der Trennlinie ist die elektrische Leitfähigkeit im Bereich der Trennlinie vermindert.

Bei einer weiteren bevorzugten Ausführungsform ist die mindestens eine Trennlinie durch eine linienförmige Anordnung von Ausnehmungen in der ersten Elektrode gebildet. Bei dieser Ausgestaltung ist die erste Elektrode mit anderen Worten entlang der Trennlinie perforiert, sodass eine elektrische Verbindung zwischen dem Bereich des ersten Leuchtsegments und dem Bereich des zweiten Leuchtsegments nur durch die zwischen den Ausnehmungen angeordneten Bereiche der ersten Elektrode im Bereich der Trennschicht besteht.

Die linienförmige Vertiefung oder die linienförmige Anordnung von Ausnehmungen in der ersten Elektrode werden vorzugsweise durch Laserablation oder durch einen Ätzprozess, insbesondere einen fotolithografischen Ätzprozess, erzeugt.

Erfindungsgemäß umrandet die Trennlinie das zweite Leuchtsegment vollständig. Bei dieser Ausgestaltung ist das zweite Leuchtsegment vollständig innerhalb des ersten Leuchtsegments angeordnet. Auf diese Weise kann vorteilhaft ein zweites Leuchtsegment mit einer vorgegebenen zweiten Helligkeit innerhalb eines ersten Leuchtsegments mit einer vorgegeben ersten Helligkeit erzeugt werden.

Gemäß einer weiteren Ausführungsform weist die erste Elektrode in dem zweiten Leuchtsegment mindestens eine weitere Trennlinie auf, welche ein drittes Leuchtsegment von dem zweiten Leuchtsegment trennt, wobei das dritte Leuchtsegment im Betrieb eine geringere Helligkeit aufweist als das zweite Leuchtsegment. Die weitere Trennlinie ist hinsichtlich ihrer vorteilhaften Ausgestaltungen wie die zuvor beschriebene Trennlinie zwischen dem ersten Leuchtsegment und dem zweiten Leuchtsegment ausgeführt. Insbesondere kann die weitere Trennlinie das dritte Leuchtsegment vollständig umranden, sodass das dritte Leuchtsegment vollständig innerhalb des zweiten Leuchtsegments angeordnet ist.

Dadurch, dass die erste Elektrode im Bereich der weiteren Trennlinie eine verringerte elektrische Leitfähigkeit aufweist, ist der Stromfluss durch das dritte Leuchtsegment, das durch die weitere Trennlinie von dem zweiten Leuchtsegment separiert ist, noch geringer als in dem zweiten Leuchtsegment. Die organische Leuchtdiode zeichnet sich bei dieser Ausgestaltung also durch mindestens drei verschiedene Helligkeiten in den Leuchtsegmenten aus.

Es ist möglich, in dem dritten Leuchtsegment noch eine weitere Trennlinie einzufügen, um ein viertes Leuchtsegment mit einer noch weiter verminderten Helligkeit von dem dritten Leuchtsegment zu separieren. Das vorgeschlagene Prinzip, bei dem durch das Einfügen einer Trennlinie mit verminderter elektrischer Leitfähigkeit ein Leuchtsegment mit verminderter Helligkeit von einem umgebenden Leuchtsegment mit größerer Helligkeit abgegrenzt wird, kann stufenweise fortgesetzt werden, um mehrere Helligkeitsabstufungen in der organischen Leuchtdiode zu erzielen. Die mehreren Leuchtsegmente können vorteilhaft trotz der verschiedenen Helligkeiten über eine gemeinsame Stromzuführung, deren Anschlussstelle an dem Leuchtsegment mit der größten Helligkeit angeordnet ist, mit Strom versorgt werden. Es sind also insbesondere keine separaten Zuleitungen für die Leuchtsegmente mit den verschiedenen Helligkeiten erforderlich.

Gemäß einer vorteilhaften Ausführungsform ist die erste Elektrode auf einem Substrat der organischen Leuchtdiode angeordnet, und ein organischer Schichtenstapel, welcher eine lichtemittierende aktive Schicht umfasst, auf der ersten Elektrode angeordnet. Die erste Elektrode kann insbesondere die Anode der organischen Leuchtdiode ausbilden und beispielsweise auf einem Glassubstrat angeordnet sein.

Die zweite Elektrode der organischen Leuchtdiode ist vorteilhaft an einer der ersten Elektrode gegenüberliegenden Seite des organischen Schichtenstapels angeordnet und kann insbesondere die Kathode der organischen Leuchtdiode sein. Die zweite Elektrode ist vorteilhaft nicht strukturiert, da die verschiedenen Stromstärken durch die Leuchtsegmente durch die Strukturierung der ersten Elektrode eingestellt werden. Die zweite Elektrode weist vorteilhaft wie die erste Elektrode nur einen einzigen Anschlusskontakt zur Verbindung mit einer Strom- oder Spannungsquelle auf. Die organische Leuchtdiode kann daher über nur zwei Zuleitungen, die zu den Anschlusskontakten an der ersten Elektrode und der zweiten Elektrode führen, mit einer Strom- oder Spannungsquelle verbunden werden.

Die organische Leuchtdiode kann als so genannter Bottom-Emitter ausgeführt sein, welcher Strahlung durch ein transparentes Substrat emittiert. Alternativ kann die organische Leuchtdiode eine beidseitig emittierende organische Leuchtdiode sein, wenn insbesondere sowohl die erste Elektrode als auch die zweite Elektrode transparent ausgeführt sind. In Abhängigkeit von der Ausgestaltung der Elektroden als transparent oder reflektierend und/oder dem Einfügen einer Reflexionsschicht kann die organische Leuchtdiode als Top-Emitter, Bottom-Emitter oder beidseitig emittierende organische Leuchtdiode ausgeführt sein.

Gemäß einer vorteilhaften Ausführungsform ist die mindestens eine Trennlinie in der ersten Elektrode mit einer elektrisch isolierenden Schicht bedeckt. Dies hat den Vorteil, dass der durch die Trennlinie erzeugte Bereich mit verminderter elektrischer Leitfähigkeit nicht durch eine darüber angeordnete elektrisch leitfähige Schicht, insbesondere eine Schicht des organischen Schichtenstapels der Leuchtdiode, kurzgeschlossen wird. Bei dieser Ausgestaltung ist die elektrisch isolierende Schicht vorteilhaft in etwa wie die Trennlinie strukturiert, so dass sie im Wesentlichen nur die Trennlinie, nicht aber die übrigen Bereiche der ersten Elektrode bedeckt. Die elektrisch isolierende Schicht ist vorzugsweise eine transparente Polymerschicht.

Gemäß zumindest einer Ausführungsform bildet zumindest eines der Leuchtsegmente ein grafisches Element aus. Das grafische Element kann insbesondere ein Bild, ein Symbol oder mindestens ein Schriftzeichen darstellen. Die in der ersten Elektrode erzeugte Trennlinie bildet in diesem Fall den äußeren Umriss des grafischen Elements.

Gemäß zumindest einer Ausführungsform weist die Trennlinie eine Breite zwischen 25 µm und 100 µm auf. Durch die Einstellung der Breite der Trennlinie kann die Helligkeitsdifferenz zwischen den durch die Trennlinie getrennten Leuchtsegmenten gezielt eingestellt werden.

Die erste Elektrode ist vorzugsweise eine transparente Elektrode. Insbesondere kann die erste Elektrode ein transparentes leitfähiges Oxid (TCO, Transparent Conductive Oxide) aufweisen. Transparente leitfähige Oxide sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO).

Die Erfindung wird im Folgenden anhand von Ausführungsbeispielen im Zusammenhang mit den Figuren 1 bis 3 näher erläutert.

Es zeigen:
Figur 1A eine schematische Darstellung eines Querschnitts durch eine organische Leuchtdiode gemäß einem ersten Ausführungsbeispiel,
Figur 1B eine schematische Darstellung einer Aufsicht auf die erste Elektrode der organischen Leuchtdiode gemäß dem ersten Ausführungsbeispiel,
Figur 2 eine schematische Darstellung einer Aufsicht auf die erste Elektrode einer organischen Leuchtdiode gemäß einem zweiten Ausführungsbeispiel, und
Figur 3 eine schematische Darstellung einer Aufsicht auf die erste Elektrode einer organischen Leuchtdiode gemäß einem dritten Ausführungsbeispiel.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

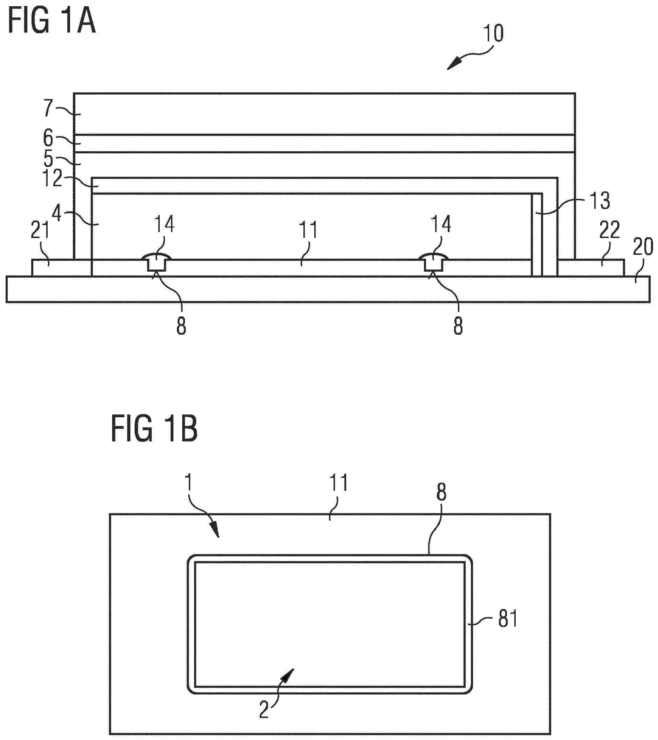

Die organische Leuchtdiode 10 gemäß dem ersten Ausführungsbeispiel, von der Figur 1A einen Querschnitt und Figur 1B eine Aufsicht auf die erste Elektrode zeigt, weist einen organischen Schichtenstapel 4 auf, der zwischen einer ersten Elektrode 11 und einer zweiten Elektrode 12 angeordnet ist. Die erste Elektrode 11 und die zweite Elektrode 12 sind bei dem Ausführungsbeispiel durch eine elektrisch isolierende Schicht 13 voneinander isoliert.

Der organische Schichtenstapel 4 ist durch eine zur Emission von Strahlung geeignete Schichtenfolge gebildet, deren Teilschichten zur Vereinfachung nicht dargestellt sind. Der organische Schichtenstapel 4 weist insbesondere mindestens eine organische elektrolumineszierende aktive Schicht auf. Der organische funktionelle Schichtenstapel 4 kann weiterhin beispielsweise eine Löcherinjektionsschicht, eine Löchertransportschicht, eine Elektronenblockierschicht, eine Löcherblockierschicht, eine Elektronentransportschicht und/oder eine Elektroneninjektionsschicht aufweisen, die geeignet sind, Löcher bzw. Elektronen zu der organischen elektrolumineszierenden Schicht zu leiten bzw. den jeweiligen Transport zu blockieren. Geeignete Schichtanordnungen und Materialien für organische Leuchtdioden sind an sich bekannt und werden daher nicht im Detail erläutert.

Die organische Leuchtdiode 10 weist bei dem Ausführungsbeispiel ein Substrat 20 auf, das ein transparentes oder transluzentes Substrat 20 wie zum Beispiel Glassubstrat oder ein Polymersubstrat sein kann. Vorzugsweise tritt elektromagnetische Strahlung aus der der ersten Elektrode 11 abgewandten Seite des Substrats 20 aus. Wahlweise kann die der ersten Elektrode 11 abgewandte Seite des Substrats 20 verspiegelt sein. Wahlweise oder zusätzlich kann elektromagnetische Strahlung aus der dem Substrat 20 abgewandten Seite der zweiten Elektrode 12 austreten. In diesem Fall ist die zweite Elektrode 12 vorzugsweise transparent oder transluzent. Die organische Leuchtdiode 10 kann somit ein Top-Emitter oder ein Bottom-Emitter sein oder in beide Richtungen elektromagnetische Strahlung emittieren.

Dem Substrat 20 folgen die erste Elektrode 11, der organische Schichtenstapel 4 und die zweite Elektrode 12 nach. Die erste Elektrode 11 ist bei dem Ausführungsbeispiel über einen Anschlusskontakt 21 und die zweite Elektrode 12 über einen Anschlusskontakt 22 an eine Strom- oder Spannungsquelle anschließbar.

Zum Schutz des organischen Schichtenstapels 4 und der Elektroden 11, 12 vor äußeren Einflüssen, insbesondere zum Schutz gegen das Eindringen von Feuchtigkeit und/oder gegen Oxidation, kann die organische Leuchtdiode 10 eine DünnfilmVerkapselung 5 aufweisen, welche z. B. aus einer oder mehreren Oxid-, Nitrid- oder Oxinitridschichten gebildet ist. Geeignete Materialien für die Schichten der Dünnfilmverkapselung sind beispielsweise Aluminiumoxid, Zinkoxid, Zirkoniumoxid, Titanoxid, Hafniumoxid, Lanthanoxid oder Tantaloxid. Bevorzugt weist die Verkapselung eine Schichtenfolge mit einer Mehrzahl dünner Schichten auf, die jeweils eine Dicke zwischen einer Atomlage und einigen 100 nm aufweisen. Weiterhin kann die organische Leuchtdiode an einer vom Substrat 20 abgewandten Seite z. B. mit einer Klebstoffschicht 6 mit einem Deckglas 7 verbunden sein.

Die organische Leuchtdiode 10 strahlt im Betrieb in einem ersten Leuchtsegment 1 Strahlung mit einer ersten Helligkeit und in einem zweiten Leuchtsegment 2 Strahlung mit einer geringeren zweiten Helligkeit ab. Dies wird bei der organischen Leuchtdiode 10 vorteilhaft durch eine Strukturierung der ersten Elektrode 11 erzielt. Wie in der Figur 1B dargestellten Aufsicht auf die erste Elektrode 11 zu erkennen ist, werden das erste Leuchtsegment 1 und das zweite Leuchtsegment 2 durch eine Trennlinie 8 in der ersten Elektrode 11 definiert. Das erste Leuchtsegment 1 wird durch den Bereich der ersten Elektrode 11 außerhalb der Trennlinie 8 und das zweite Leuchtsegment durch den Bereich der ersten Elektrode 11 innerhalb der Trennlinie 8 definiert. Das zweite Leuchtsegment 2 wird von der Trennlinie 8 vollständig umrandet. Bei dem Ausführungsbeispiel weist die Trennlinie 8 die Form eines Rechtecks auf. Die Trennlinie 8 kann alternativ je nach gewünschter Form des zweiten Leuchtsegments 2 eine andere Form aufweisen.

Wie in der Querschnittsdarstellung der Figur 1A zu erkennen ist, kann es sich bei der Trennlinie 8 insbesondere um eine linienförmige Vertiefung 81 in der ersten Elektrode 11 handeln. Bei dem Ausführungsbeispiel bildet die Trennlinie 8 einen rechteckförmigen Umriss des zweiten Leuchtsegments 2 aus. Die Trennlinie 8 kann alternativ auch einen beliebigen anderen Umriss aufweisen, insbesondere den Umriss eines Logos, eines Symbols oder eines Schriftzeichens.

Dadurch, dass die Trennlinie 8 durch eine Vertiefung 81 in der ersten Elektrode 11 gebildet ist, ist die elektrische Leitfähigkeit der ersten Elektrode 11 im Bereich der Trennlinie 8 vermindert. Dadurch wird erreicht, dass der Stromfluss durch das zweite Leuchtsegment 2 beim Betrieb der organischen Leuchtdiode 10 im Vergleich zum ersten Leuchtsegment 1 vermindert ist. Das zweite Leuchtsegment 2 strahlt daher im Betrieb Strahlung mit einer geringeren Helligkeit ab als das erste Leuchtsegment 1. Zur Erzielung der unterschiedlichen Helligkeiten in den Leuchtsegmenten 1, 2 sind vorteilhaft keine separaten Anschlusskontakte für das erste Leuchtsegment 1 und das zweite Leuchtsegment 2 nötig. Vielmehr weist die erste Elektrode 11 einen einzigen Anschlusskontakt 21 und die zweite Elektrode 12 einen einzigen Anschlusskontakt 22 auf. Der Anschlusskontakt 21 der ersten Elektrode 11 grenzt an das erste Leuchtsegment 1 an, welches zur Emission von Strahlung mit der größeren Helligkeit vorgesehen ist. Das zweite Leuchtsegment 2 ist über das erste Leuchtsegment 1 und den Bereich der verminderten elektrischen Leitfähigkeit der Trennlinie 8 ebenfalls mit dem ersten Anschlusskontakt 21 elektrisch leitend verbunden. Eine separate Zuleitung für das zweite Leuchtsegment 2 ist daher nicht erforderlich.

Der Stromfluss durch das zweite Leuchtsegment 2 und die daraus resultierende Helligkeit können insbesondere durch die Breite der Vertiefung 81 und/oder die Tiefe der Vertiefung 81 eingestellt werden. Die Breite der Vertiefung 81 kann beispielsweise zwischen 25 µm und 100 µm betragen. Die Dicke der ersten Elektrode 11 kann im Bereich der Trennlinie 8 beispielsweise um mindestens 25 %, um mindestens 50 % oder sogar um mindestens 75 % gegenüber den angrenzenden Bereichen der Leuchtsegmente 1, 2, vermindert sein. Außerhalb der Trennlinie 8 weist die erste Elektrode vorteilhaft eine konstante Dicke auf, d.h. die Dicke der ersten Elektrode 11 unterscheidet sich im ersten Leuchtsegment 1 und im zweiten Leuchtsegment 2 nicht. Die ersten Elektrode 11 kann daher abgesehen von der Herstellung der Trennlinie 8 vorteilhaft mit einem herkömmlichen Beschichtungsverfahren aufgebracht werden. Außerhalb der Trennlinie kann die Dicke der ersten Elektrode 11 zum Beispiel zwischen 20 nm und 1 µm, bevorzugt zwischen 100 nm und 200 nm, betragen.

Die Vertiefung 81 zur Erzeugung der Trennlinie 8 kann beispielsweise durch Laserablation erzeugt werden. Dabei beträgt der Durchmesser des Laserstrahls vorzugsweise zwischen 25 µm und 100 µm, besonders bevorzugt 60 µm oder weniger. Dabei entspricht der Durchmesser des Laserstrahls im Wesentlichen der Linienbreite der Trennlinie. Bei dem Laser kann es sich um einen diodengepumpten Festkörperlaser handeln. Der Laser kann Laserstrahlung im UV-Bereich erzeugen, beispielsweise mit einer Wellenlänge von 370 nm. Die Leistung des Lasers kann beispielsweise zwischen 1 W und 4 W betragen.

Wahlweise oder zusätzlich kann die Herstellung der Trennlinie 8 das zumindest teilweise Abtragen der ersten Elektrode 11 durch Ätzen umfassen. Das Ätzen kann nasschemisches Ätzen, insbesondere photochemisches Ätzen mit einer Mischung aus Salpetersäure und Eisen-(III)-Chlorid umfassen. Wahlweise oder zusätzlich kann das Ätzen Trockenätzen, insbesondere Plasmaätzen umfassen. Das Ätzen bietet gegenüber der Laserablation den Vorteil, dass es einfacher ist, eine Beschädigung des Glassubstrats zu vermeiden.

Die erste Elektrode 11 kann insbesondere die Anode der organischen Leuchtdiode 10 sein. Vorzugsweise ist die erste Elektrode 11 eine transparente Elektrode, die beispielsweise ein transparentes leitfähiges Oxid aufweist. Bevorzugt weist die erste Elektrode 11 ITO auf. Die an der gegenüberliegenden Seite des organischen Schichtenstapels 4 angeordnete zweite Elektrode 12 kann z. B. eine dünne Metallschicht sein.

Die Vertiefung 81, welche die Trennlinie 8 ausbildet, ist vorzugsweise durch eine elektrisch isolierende Schicht 14 von der organischen Schichtenfolge 4 elektrisch isoliert. Dies hat den Vorteil, dass der Bereich mit verminderter elektrischer Leitfähigkeit nicht durch eine angrenzende Schicht der organischen Schichtenfolge 4 kurzgeschlossen wird, wodurch sich der Effekt der verminderten elektrischen Leitfähigkeit verringern würde.

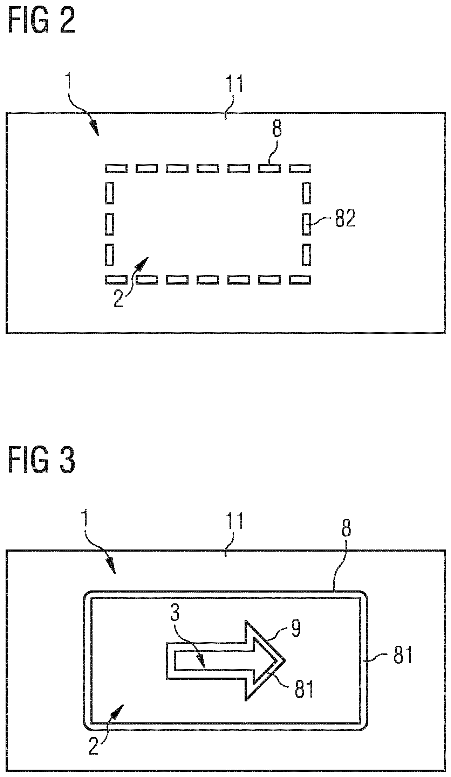

Figur 2 zeigt eine Aufsicht auf eine alternative Ausgestaltung der ersten Elektrode 11 bei einem weiteren Ausführungsbeispiel. Bei diesem Ausführungsbeispiel wird die erste Elektrode 11 nicht durch eine Vertiefung, sondern durch eine linienförmige Anordnung von Ausnehmungen 82 in der ersten Elektrode 11 gebildet. In den Ausnehmungen 82 kann die erste Elektrode bis zur Oberfläche des Substrats abgetragen sein. Der Umriss des zweiten Leuchtsegments 2, der durch die Trennlinie 8 gebildet wird, ist wie bei dem ersten Ausführungsbeispiel rechteckförmig. Die elektrische Leitfähigkeit ist aufgrund der Ausnehmungen 82 in der ersten Elektrode 11 im Bereich der Trennlinie 8 vermindert.

Die Ausnehmungen 82 können z. B. wie die zuvor beschriebene Vertiefung durch Laserablation oder durch einen Ätzprozess in der ersten Elektrode 11 erzeugt werden. Weiterhin können die Ausnehmungen 82 wie die Vertiefungen des ersten Ausführungsbeispiels mit einer elektrisch isolierenden Schicht bedeckt sein. Der Aufbau der organischen Leuchtdiode und weitere vorteilhafte Ausgestaltungen entsprechen ansonsten dem ersten Ausführungsbeispiel.

In Figur 3 ist noch eine weitere Ausgestaltung der ersten Elektrode 11 bei einem dritten Ausführungsbeispiel der organischen Leuchtdiode dargestellt. Bei diesem Ausführungsbeispiel weist die organische Leuchtdiode 10 ein erstes Leuchtsegment 1, ein zweites Leuchtsegment 2 und ein drittes Leuchtsegment 3 auf. Das zweite Leuchtsegment 2 wird wie bei dem ersten Ausführungsbeispiel durch eine rechteckförmige Trennlinie 8, die durch eine Vertiefung in der ersten Elektrode 11 gebildet wird, von dem ersten Leuchtsegment 1 getrennt.

Bei dem dritten Ausführungsbeispiel ist zusätzlich innerhalb des zweiten Leuchtsegments 2 eine weitere Trennlinie 9 in der ersten Elektrode 11 angeordnet, welche wie die erste Trennlinie 8 durch eine Vertiefung 81 gebildet sein kann. Die weitere Trennlinie 9 kann die gleichen Ausgestaltungen aufweisen wie die zuvor beschriebene Trennlinie 8 zwischen dem ersten Leuchtsegment 1 und dem zweiten Leuchtsegment 2. Die Vertiefungen 81, welche die Trennlinie 8 und die weitere Trennlinie 9 ausbilden, können wie die Vertiefungen des ersten Ausführungsbeispiels mit einer elektrisch isolierenden Schicht bedeckt sein.

Die weitere Trennlinie 9 trennt ein drittes Leuchtsegment 3 von dem zweiten Leuchtsegment 2 ab, wobei aufgrund der verringerten elektrischen Leitfähigkeit im Bereich der weiteren Trennlinie 9 der Stromfluss durch das dritte Leuchtsegment 3 im Vergleich zum zweiten Leuchtsegment 2 noch weiter vermindert ist.

Die weitere Trennlinie 9 weist bei dem Ausführungsbeispiel die Form eines grafischen Symbols in Form eines Pfeils auf. Die organische Leuchtdiode kann in diesem Fall beispielsweise als Hinweisschild verwendet werden, das eine Richtung anzeigt. Alternativ könnte durch eine andere Gestaltung der Trennlinien 8, 9 ein beliebiges anderes grafisches Symbol, ein Logo oder ein Schriftzug von der organischen Leuchtdiode dargestellt werden.

Die weitere Trennlinie 9 könnte, wie bei dem zweiten Ausführungsbeispiel, anstatt durch eine Vertiefung 81 durch eine linienförmige Anordnung von Ausnehmungen in der ersten Elektrode 11 gebildet sein, wie die Trennlinie des zuvor beschriebenen zweiten Ausführungsbeispiels.

Es ist weiterhin möglich, innerhalb des dritten Leuchtsegments 3 eine oder mehrere weitere Trennlinien vorzusehen, um weitere Segmente mit noch geringerer Helligkeit zu erzeugen (nicht dargestellt). Durch das Einfügen einer Trennlinie 8, 9 in ein Leuchtsegment 1, 2, 3 mit einer vorgegebenen Helligkeit kann jeweils ein eingeschlossenes Leuchtsegment mit einer geringeren Helligkeit erzeugt werden. Dieses Prinzip kann mehrfach wiederholt werden, sodass eine Vielzahl von Leuchtsegmenten mit stufenweise abnehmender Helligkeit erzeugt werden kann. Wie das zweite Leuchtsegment 2 ist auch für das dritte Leuchtsegment 3 keine separate Zuleitung zur Stromversorgung erforderlich. Der Abstand zwischen den Leuchtsegmenten 1, 2, 3 kann daher vorteilhaft sehr gering sein und insbesondere nur der Breite der Trennlinien 8, 9 entsprechen.

Die Erfindung ist nicht durch die Beschreibung anhand der Ausführungsbeispiele beschränkt.

## Patentansprüche

1. Organische Leuchtdiode (10), umfassend ein erstes Leuchtsegment (1) und mindestens ein zweites Leuchtsegment (2), wobei die Leuchtsegmente (1, 2) zur Emission von Strahlung mit verschiedenen Helligkeiten vorgesehen sind und eine gemeinsame erste Elektrode (11) und eine gemeinsame zweite Elektrode (12) aufweisen, wobei
- die erste Elektrode (11) mindestens eine Trennlinie (8) aufweist, welche die erste Elektrode (11) nicht vollständig durchtrennt,
- die laterale elektrische Leitfähigkeit der ersten Elektrode (11) im Bereich der Trennlinie (8) vermindert ist,
- die Trennlinie (8) das erste Leuchtsegment (1) von dem zweiten Leuchtsegment (2) trennt,
- das zweite Leuchtsegment (2) im Betrieb eine geringere Helligkeit als das erste Leuchtsegment (1) aufweist, **dadurch gekennzeichnet, dass**
- die Trennlinie (8) das zweite Leuchtsegment (2) vollständig umrandet.

2. Organische Leuchtdiode nach Anspruch 1,
wobei die erste Elektrode (11) und die zweite Elektrode (12) jeweils einen einzigen Anschlusskontakt (21, 22) zur Verbindung der organischen Leuchtdiode (10) mit einer Strom- oder Spannungsquelle aufweisen.

3. Organische Leuchtdiode nach einem der vorhergehenden Ansprüche,
wobei ein elektrischer Anschlusskontakt (21) der ersten Elektrode (11) an das erste Leuchtsegment (1) angrenzt.

4. Organische Leuchtdiode nach einem der vorhergehenden Ansprüche,
wobei die mindestens eine Trennlinie (8) durch eine linienförmige Vertiefung (81) in der ersten Elektrode (11) gebildet ist.

5. Organische Leuchtdiode nach einem der vorhergehenden Ansprüche,
wobei die mindestens eine Trennlinie (8) durch eine linienförmige Anordnung von Ausnehmungen (82) in der ersten Elektrode (11) gebildet ist.

6. Organische Leuchtdiode nach einem der vorhergehenden Ansprüche,
wobei die erste Elektrode (11) in dem zweiten Leuchtsegment (2) mindestens eine weitere Trennlinie (9) aufweist, welche ein drittes Leuchtsegment (3) von dem zweiten Leuchtsegment (2) trennt, wobei das dritte Leuchtsegment (3) im Betrieb eine geringere Helligkeit aufweist als das zweite Leuchtsegment (2).

7. Organische Leuchtdiode nach Anspruch 6,
wobei die weitere Trennlinie (9) das dritte Leuchtsegment (3) vollständig umrandet.

8. Organische Leuchtdiode nach einem der vorhergehenden Ansprüche,
wobei die erste Elektrode (11) auf einem Substrat (20) der organischen Leuchtdiode (10) angeordnet ist, und ein organischer Schichtenstapel (4), welcher eine lichtemittierende aktive Schicht umfasst, auf der ersten Elektrode (11) angeordnet ist.

9. Organische Leuchtdiode nach einem der vorhergehenden Ansprüche,
wobei die Trennlinie (8, 9) mit einer elektrisch isolierenden Schicht bedeckt ist.

10. Organische Leuchtdiode nach einem der vorhergehenden Ansprüche,
wobei zumindest eines der Leuchtsegmente (1, 2, 3) ein grafisches Element ausbildet.

11. Organische Leuchtdiode nach einem der vorhergehenden Ansprüche,
wobei das grafische Element ein Bild, ein Symbol oder ein Schriftzeichen ist.

12. Organische Leuchtdiode nach einem der vorhergehenden Ansprüche,
wobei die Trennlinie (8, 9) eine Breite zwischen 25 µm und 100 µm aufweist.

13. Organische Leuchtdiode nach einem der vorhergehenden Ansprüche,
wobei die Trennlinie (8) oder die weitere Trennlinie (9) durch Laserablation oder durch einen Ätzprozess hergestellt ist.

14. Organische Leuchtdiode nach einem der vorhergehenden Ansprüche,
wobei die erste Elektrode (11) eine transparente Elektrode ist.

## Claims

1. Organic light-emitting diode (10), comprising a first light-emitting segment (1) and at least a second light-emitting segment (2), wherein the light-emitting segments (1, 2) are provided for emitting radiation with different brightnesses and comprise a common first electrode (11) and a common second electrode (12),
wherein
- the first electrode (11) comprises at least one separating line (8), which does not completely cut through the first electrode (11),
- the lateral electric conductivity of the first electrode (11) is reduced in the region of the separating line (8),
- the separating line (8) separates the first light-emitting segment (1) from the second light-emitting segment (2),
- the second light-emitting segment has a lower brightness during operation than the first light-emitting segment (1),
**characterized in that**
- the separating line (8) entirely encircles the second light-emitting segment (2).

2. Organic light-emitting diode according to claim 1,
wherein the first electrode (11) and the second electrode (12) each have one single connection contact (21, 22) for connecting the organic light-emitting diode (10) to a current or voltage source.

3. Organic light-emitting diode according to one of the preceding claims,
wherein an electric connection contact (21) of the first electrode (11) adjoins the first light-emitting segment (1) .

4. Organic light-emitting diode according to one of the preceding claims,
wherein the at least one separating line (8) is formed by a line-shaped depression (81) in the first electrode (11) .

5. Organic light-emitting diode according to one of the preceding claims,
wherein the at least one separating line (8) is formed by a line-shaped arrangement of cut-outs (82) in the first electrode (11).

6. Organic light-emitting diode according to one of the preceding claims,
wherein the first electrode (11) comprises at least one further separating line (9) in the second light-emitting segment (2), the further separating line separating a third light-emitting segment (3) from the second light-emitting segment (2), wherein the third light-emitting segment (3) has a lower brightness during operation than the second light-emitting segment (2).

7. Organic light-emitting diode according to claim 6,
wherein the further separating line (9) entirely encircles the third light-emitting segment (3).

8. Organic light-emitting diode according to one of the preceding claims,
wherein the first electrode (11) is arranged on a substrate (20) of the organic light-emitting diode (10), and an organic layer stack (4), which comprises a light-emitting active layer, is arranged on the first electrode (11) .

9. Organic light-emitting diode according to one of the preceding claims,
wherein the separating line (8, 9) is covered with an electrically insulating layer.

10. Organic light-emitting diode according to one of the preceding claims,
wherein at least one of the light-emitting segments (1, 2, 3) forms a graphic element.

11. Organic light-emitting diode according to one of the preceding claims,
wherein the graphic element is an image, a symbol or a character.

12. Organic light-emitting diode according to one of the preceding claims,
wherein the separating line (8, 9) has a width of between 25 µm and 100 µm.

13. Organic light-emitting diode according to one of the preceding claims,
wherein the separating line (8) or the further separating line (9) is produced by laser ablation or by an etching process.

14. Organic light-emitting diode according to one of the preceding claims,
wherein the first electrode (11) is a transparent electrode.

## Revendications

1. Diode luminescente organique (10) comportant un premier segment luminescent (1) et au moins un second segment luminescent (2), sachant que les segments luminescents (1, 2) sont prévus en vue de l'émission de rayonnement avec différentes luminosités et présentent une première électrode commune (11) et une seconde électrode commune (12), sachant que
- la première électrode (11) présente au moins une ligne séparatrice (8), qui ne sectionne pas complètement la première électrode (11),
- la conductibilité électrique latérale de la première électrode (11) est réduite dans la zone de la ligne séparatrice (8),
- la ligne séparatrice (8) sépare le premier segment luminescent (1) du second segment luminescent (2),
- le second segment luminescent (2) présente en fonctionnement une luminosité plus faible que le premier segment luminescent (1),
**caractérisée en ce que**
- la ligne séparatrice (8) encadre complètement le second segment luminescent (2).

2. Diode luminescente organique selon la revendication 1,
sachant que la première électrode (11) et la seconde électrode (12) présentent respectivement un unique contact de connexion (21, 22) en vue de la liaison de la diode luminescente organique (10) avec une source de courant ou de tension.

3. Diode luminescente organique selon une quelconque des revendications précédentes,
sachant qu'un contact de connexion électrique (21) de la première électrode (11) est adjacent au premier segment luminescent (1).

4. Diode luminescente organique selon une quelconque des revendications précédentes,
sachant que la au moins une ligne de séparation (8) est constituée par une cavité linéaire (81) dans la première électrode (11).

5. Diode luminescente organique selon une quelconque des revendications précédentes,
sachant que la au moins une ligne de séparation (8) est constituée par une disposition linéaire de creux (82) dans la première électrode (11).

6. Diode luminescente organique selon une quelconque des revendications précédentes,
sachant que la première électrode (11) dans le second segment luminescent (2) présente au moins une autre ligne séparatrice (9), qui sépare un troisième segment luminescent (3) du second segment luminescent (2),
sachant que le troisième segment luminescent (3) présente en fonctionnement une luminosité plus faible que le second segment luminescent (2).

7. Diode luminescente organique selon la revendication 6,
sachant que l'autre ligne séparatrice (9) encadre complètement le troisième segment luminescent (3).

8. Diode luminescente organique selon une quelconque des revendications précédentes,
sachant que la première électrode (11) est disposée sur un substrat (20) de la diode luminescente organique (10), et une pile de couches organiques (4), qui comporte une couche active électroluminescente, est disposée sur la première électrode (11).

9. Diode luminescente organique selon une quelconque des revendications précédentes,
sachant que la ligne séparatrice (8, 9) est recouverte par une couche isolante électriquement.

10. Diode luminescente organique selon une quelconque des revendications précédentes,
sachant qu'au moins un des segments luminescents (1, 2, 3) constitue un élément graphique.

11. Diode luminescente organique selon une quelconque des revendications précédentes,
sachant que l'élément graphique est une image, un symbole ou un caractère.

12. Diode luminescente organique selon une quelconque des revendications précédentes,
sachant que la ligne séparatrice (8, 9) présente une largeur entre 25 µm et 100 µm.

13. Diode luminescente organique selon une quelconque des revendications précédentes,
sachant que la ligne séparatrice (8) ou l'autre ligne séparatrice (9) est produite par ablation laser ou par un procédé de gravure.

14. Diode luminescente organique selon une quelconque des revendications précédentes,
sachant que la première électrode (11) est une électrode transparente.
